# EUROPÄISCHE PATENTSCHRIFT

(11) **EP 0 731 509 B1**
(45) Veröffentlichungstag und Bekanntmachung des Hinweises auf die Patenterteilung: **06.06.2001**
(21) Anmeldenummer: 96103353.7
(22) Anmeldetag: 04.03.1996
(51) Int. Cl.: H01L 31/0232, H01L 33/00

(54) **Optoelektronischer Wandler und Herstellverfahren**
Optoelectronic converter and process of manufacturing
Convertisseur optoélectronique et procédé de fabrication

(30) Priorität: 08.03.1995 DE 19508222
(43) Veröffentlichungstag der Anmeldung: 11.09.1996
(73) Patentinhaber: Infineon Technologies AG, 81669 München (DE)
(72) Erfinder: Späth, Werner, Dipl.-Phys., 83607 Holzkirchen (DE); Gramann, Wolfgang, Ing. grad., 93057 Regensburg (DE); Bogner, Georg, Dipl.-Phys., 93051 Regensburg (DE); Dietrich, Ralf, Ing. grad., 81543 München (DE)
(74) Vertreter: Zedlitz, Peter, Dipl.-Inf.

(56) Entgegenhaltungen:
- EP-A- 0 094 598
- DE-A- 2 900 356
- US-A- 4 055 761
- US-A- 5 167 724
- US-A- 5 274 456
- DATABASE WPI Section EI, Week 9516 Derwent Publications Ltd., London, GB; Class T04, AN 95-118405 XP002006158 & JP-A-70 400 589 (KYOCERA CORP) , 10.Februar 1995
- PATENT ABSTRACTS OF JAPAN vol. 94, no. 011 & JP-A-06 326831 (KYOCERA CORP), 25.November 1994,
- PATENT ABSTRACTS OF JAPAN vol. 017, no. 661 (E-1471), 7.Dezember 1993 & JP-A-05 218463 (SUMITOMO ELECTRIC IND LTD), 27.August 1993,

## Beschreibung

Die Erfindung bezieht sich auf einen optoelektronischen Wandler mit einem Strahlung empfangenden oder aussendenden Halbleiterbauelement, mit einer Bodenplatte, auf dem das Halbleiterbauelement befestigt ist und mit einem mit der Trägerplatte verbundenen Abstandhalter für ein optisch auf das Halbleiterbauelement ausgerichtetes Linsensystem, wobei die Bodenplatte, der Abstandhalter und das Linsensystem aus Materialien mit zumindest ähnlichen thermischen Ausdehnungskoeffizienten bestehen.

Solche Wandler sind beispielsweise aus der US 4 055 761 oder der JP 5-218 463 bekannt.

Weiterhin sind in der JP-A-7040589 und in der JP-A-6326831 Anzeigegeräte beschrieben, bei denen auf einer Bodenplatte mittels Abstandhalter eine Linsenplatte befestigt ist. Bodenplatte, Abstandhalten und Linsenplatte weisen nahezu denselben thermischen Ausdehnungskoeffiezienten auf.

Ein wesentliches Problem besteht darin, die Wandler mit gutem Wirkungsgrad zu betreiben. Dies wird, abgesehen von den Eigenschaften des Halbleiterbauelements selbst, dadurch erreicht, daß das Linsensystem optisch optimal auf das Halbleiterbauelement ausgerichtet wird. Nur dann läßt sich das Licht vom Halbleiterbauelement mit hohem Wirkungsgrad auf einen Lichtleiter auskoppeln oder von einem Lichtleiter auf das Halbleiterbauelement einkoppeln.

Bei einem optoelektronischen Wandler muß außerdem sichergestellt werden, daß die optimale Justierung auch im Betrieb erhalten bleibt. Bei Erwärmung des Wandlers im Betrieb kann es nämlich zu Dejustierungen kommen, die den Wirkungsgrad verschlechtern.

Der Erfindung liegt die Aufgabe zugrunde, einen optoelektronischen Wandler der eingangs erwähnten Art so zu verbessern, daß Temperaturschwankungen nur noch einen geringen Einfluß auf die Justierung zwischen Halbleiterbauelement und Linsensystem haben. Außerdem soll ein einfaches Verfahren zum Herstellen eines solchen optoelektronischen Wandlers angegeben werden.

Das erstgenannte Ziel wird dadurch erreicht, daß die Bodenplatte, der Abstandhalter und das Linsensystem aus Materialien mit zumindest ähnlichen thermischen Ausdehnungskoeffizienten bestehen.

Weiterbildungen der Erfindung sind Gegenstand der Unteransprüche 2 bis 8. Ein bevorzugtes Verfahren zur Herstellung des optoelektonischen Wandlers ist Gegenstand des Anspruchs 9.

Die Erfindung wird anhand zweier Ausführungsbeispiele in Verbindung mit den Figuren 1 bis 5 näher erläutert. Es zeigen
- Figur 1: einen Schnitt durch ein erstes Ausführungsbeispiel,
- Figur 2: einen Schnitt durch ein zweites Ausführungsbeispiel,
- Figur 3 und 4: charakteristische Schritte bei der Herstellung des optoelektronischen Wandlers und
- Figur 5: ein Gehäuse mit eingesetztem Wandler.

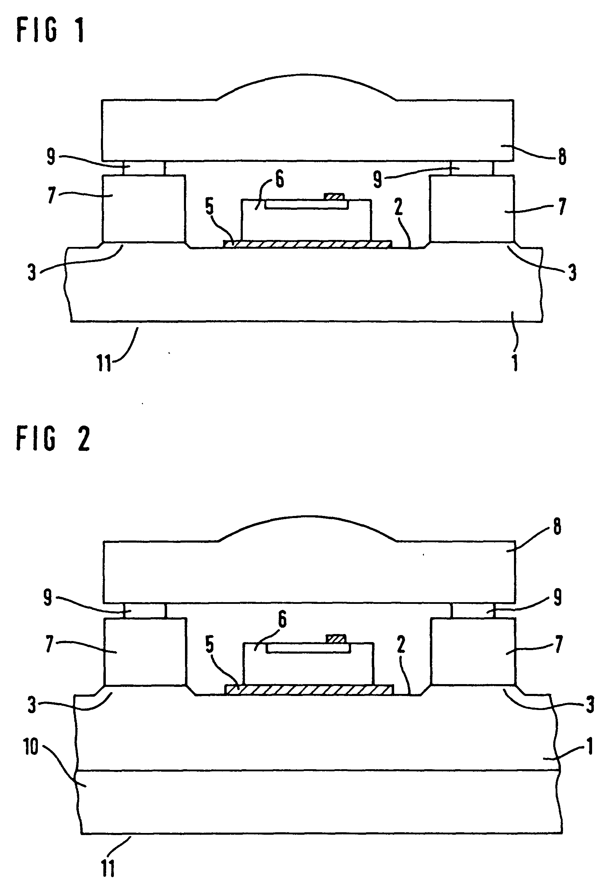

Der optoelektronische Wandler nach Figur 1 ist auf einer Bodenplatte 1 aufgebaut. Die obere Oberfläche der Bodenplatte 1 ist mit Vertiefungen 2 versehen. Beidseitig der Vertiefung 2 bleiben Stege 3 stehen. In der Vertiefung 2 ist über eine Metallisierung 5 ein Strahlung empfangendes oder aussendendes Halbleiterbauelement 6 befestigt. Dieses kann z.B. eine Fotodiode bzw. eine lichtaussendende Diode (LED) oder ein Vertical Cavity Surface Emitter Laser (VCSEL) sein. Die Metallisierung 5 dient außerdem zur Stromzuführung zum Halbleiterbauelement 6. Ein zweiter Kontakt liegt auf der Oberseite des Halbleiterbauelementes.

Auf den Stegen 3 sind z.B. ebenfalls stegförmige Abstandhalter 7 befestigt. Auf den Abstandhaltern 7 liegt ein Linsensystem 8, das mit den Abstandhaltern stoffschlüssig verbunden ist. Der Abstand zwischen dem Linsensystem und dem Boden der Vertiefung 2 ist größer als die Dicke des Halbleiterbauelements 6 zuzüglich der Metallschicht 5.

Die Bodenplatte 1 besteht aus Silizium. Dieses kann polykristallin oder monokristallin sein. Anstelle von Silizium kann für die Bodenplatte 1 jedoch auch ein anderes Material mit einem geeigneten thermischen Ausdehnungskoeffizienten verwendet werden.

Die Abstandhalter 7 bestehen aus Glas, während das Linsensystem aus Silizium oder Glas bestehen kann. Wesentlich ist, daß zwischen dem Halbleiterbauelement und dem Linsensystem wenigstens ein aus Glas bestehendes Teil angeordnet ist. Dessen geringer Wärmeleitwert verhindert, daß vom Halbleiterbauelement 6 in die Bodenplatte 1 abgeleitete Wärme zum Linsensystem gelangt. Eine Bodenplatte aus Silizium wird wegen ihrer guten Wärmeleitfähigkeit vorzugsweise bei Strahlung aussendenden Halbleiterbauelementen verwendet, da hier die umgesetzte Leistung i.a. höher als bei Strahlungsempfängern ist. Bei Strahlungsempfängern kann die Bodenplatte 1 aus Glas bestehen, die Abstandhalter 7 aus Silizium und das Linsensystem 8 aus Silizium oder Glas. Silizium für das Linsensystem in beiden Fällen kann dann der Vorzug gegeben werden, wenn die Strahlung eine Wellenlänge hat, für die Silizium durchlässig ist. Dies ist bei Wellenlänge größer als 1,1 *µ*m der Fall.

Die Bodenplatte, die Abstandhalter 7 und das Linsensystem 8 können miteinander durch Kleben und/oder Löten verbunden werden. Liegen jeweils Siliziumflächen und Glasflächen aufeinander, so können diese auch durch anodisches Bonden miteinander verbunden werden. Diese Technik ist bekannt. Dabei werden die miteinander zu bondenden Teile unter einer Temperatur von z.B. 400° C aufeinandergedrückt und eine Spannung von z.B -1000 V wird am Glas angelegt. Beim Löten oder Verkleben von Abstandhalter und Linsensystem wird zwischen beide Teile eine Lot- oder Kleberschicht 9 eingefügt. Eine Lotschicht kann z.B. aufgedampft werden.

Als Glas wird ein Typ verwendet, das ein dem Silizium ähnlichen thermischen Ausdehnungskoeffizienten hat. Hierfür eignet sich z.B ein Borosilikatglas, das z.B. unter der Handelsbezeichnung "Pyrex" 7740 von der Firma Corning oder Tempax von der Firma Schott in den Handel kommt.

Soll der optoelektronische Wandler (11) eine geringe Kapazität haben, so empfiehlt sich statt der Silizium-Bodenplatte eine Glas-Bodenplatte. Ist jedoch aus Gründen der besseren Wärmeableitung eine Silizium-Bodenplatte erforderlich, so kann diese dünn ausgeführt und auf ihrer Rückseite mit einer Glasplatte 10 (Figur 2) verbunden werden. Die Glasplatte 10 kann mit der Siliziumbodenplatte entweder durch anodisches Bonden, durch Löten oder durch Kleben verbunden sein.

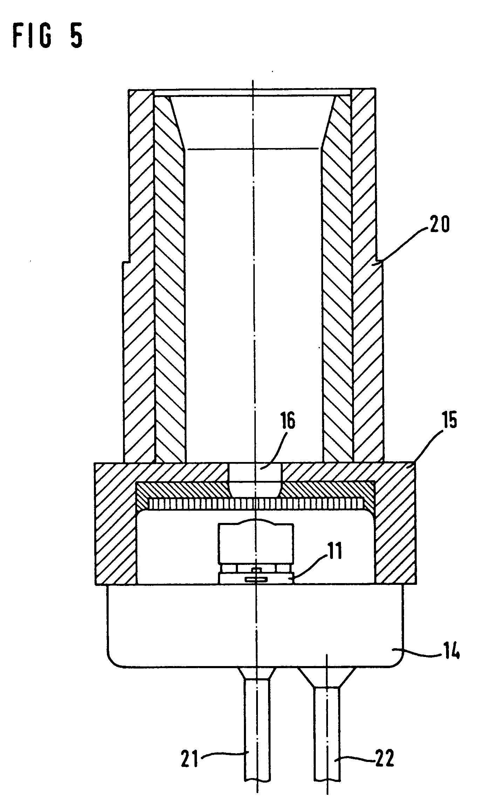

Die in Figur 1 und 2 gezeigten Wandler 11 werden in ein Gehäuse eingesetzt (Figur 5), das einen Sockel 14 und einen Deckel 15 hat. Der Wandler 11 wird relativ zu einem im Deckel 15 angebrachtes Fenster 16 justiert und auf dem Sockel 14 befestigt. An das Fenster stößt ein Lichtwellenleiter (nicht dargestellt), der durch eine Kupplung 20 mit dem Gehäuse verbunden ist. Das Halbleiterbauelement selbst ist elektrisch über die Metallisierung 5 und den auf der Oberseite des Halbleiterbauelements angeordneten Kontakt mit zwei Anschlüssen 21 und 22 verbunden, über die die Betriebsspannung zugeführt wird bzw. das elektrische Signal ausgekoppelt wird.

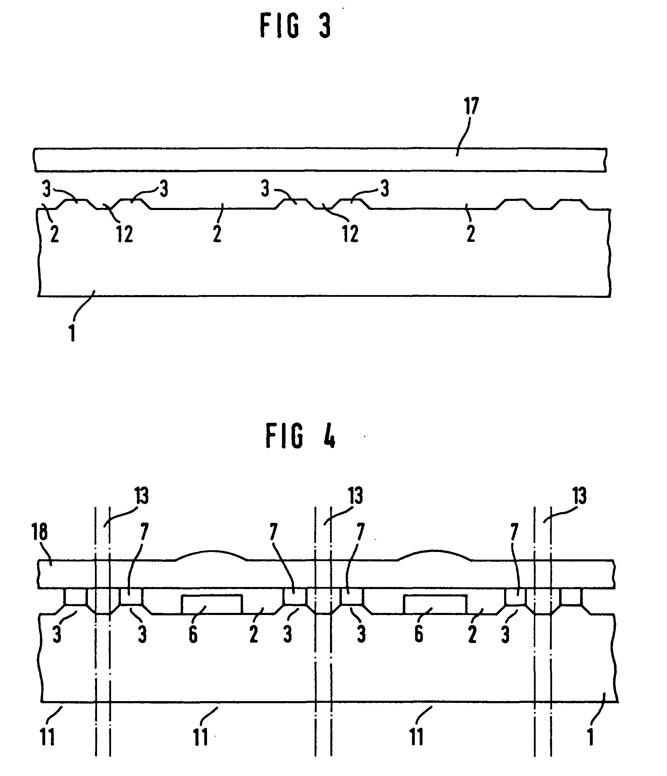

Zum gleichzeitigen Herstellen einer Vielzahl von optoelektronischen Wandlern 11 nach Figur 1 oder 2 wird zunächst eine Glasplatte oder Siliziumplatte 1 mit Vertiefungen 2 versehen (Figur 3). Diese Vertiefungen dienen der Aufnahme der Halbleiterbauelemente und sind entsprechend breit bemessen. Zwischen zwei der Vertiefungen 2 bleibt ein Steg stehen. Diese Stege werden zweckmäßigerweise durch weitere Vertiefungen 12 voneinander getrennt, wodurch Stege 3 entstehen. Die Vertiefungen 2, 12 können z.B. durch fotolithografisches Ätzen oder durch Sägen hergestellt werden. Beim Sägen entstehen einander parallele Stege 3, beim Ätzen können sie jede beliebige Form, z.B. Gitterform annehmen.

Als nächstes wird auf die Stege 3 eine aus Silizium oder Glas bestehende Platte 17 aufgelegt und mit den Stegen wie beschrieben durch anodisches Bonden, Kleben oder Verlöten verbunden. Dann wird die Platte 17 zersägt derart, daß das zwischen den Stegen 3 liegende, nicht mit der Bodenplatte 1 verbundenen Material entfernt wird. Dabei entstehen die mit den Stegen 3 verbundenen Abstandhalter 7 (Figur 4). Anschließend werden die Halbleiterbauelemente 6 gemäß einem vorgegebenen Raster in den Vertiefungen 2 befestigt.

Als nächster Schritt wird eine eine Vielzahl von Linsensystemen enthaltende Platte 18 aus Silizium oder Glas auf die Abstandhalter 7 aufgelegt. Die Linsensysteme sind in einem Raster auf der Platte 18 angeordnet, das dem Raster der auf der Bodenplatte 1 befestigten Halbleiterbauelement 6 entspricht. Die Linsensysteme werden optisch auf die Halbleiterbauelemente 6 ausgerichtet und anschließend wird die Platte 18 mit den Abstandhaltern 7 durch das beschriebene anodische Bonden oder durch Verlöten verbunden. Hierdurch entsteht ein aus Bodenplatte 1, Halbleiterbauelementen 6, Abstandhaltern 7 und Platte 18 bestehender Verbund mit einer Vielzahl von Halbleiterbauelementen und Linsensystemen. Dieser Verbund wird dann durch zwischen den Stegen 3 gelegte Sägeschnitte 13 und durch dazu rechtwinklige, parallel zur Zeichenebene liegende weitere Sägeschnitte zerlegt. Jede der dabei entstehenden Einheiten 11 wird, wie oben beschrieben, in ein Gehäuse eingesetzt.

Die Technik der Vereinzelung eines Wafers in kleine Chips ist in der Halbleitertechnik seit langem üblich und kann bei Vereinzelung des Verbundes ebenfalls angewandt werden. Der Verbund wird also durch Sägen, Ritzen und Brechen geteilt. Hierbei ist es üblich, den Verbund auf einer elastischen Klebefolie zu fixieren. Die Folie dient dann als Träger bei allen Nachfolgeprozessen.

Es ist in Abänderung des beschriebenen Verfahrens auch möglich, zunächst fotolithografisch oder mechanisch die Vertiefungen 2 und die Stege 3 zu erzeugen und dann die Abstandhalter wie beschrieben anzubringen. Anstelle einer mit vielen Linsensystemen versehenen Scheibe 18 werden dann aber einzelne Linsensysteme optisch auf die Halbleiterkörper ausgerichtet und mit den Abstandhaltern 7 verbunden.

## Patentansprüche

1. Optoelektronischer Wandler mit einem Strahlung empfangenden oder aussendenden Halbleiterbauelement mit einer Bodenplatte (1), auf dem das Halbleiterbauelement (6) befestigt ist und mit einem mit der Bodenplatte (1) verbundenen Abstandhalter (7) für ein optisch auf das Halbleiterbauelement (6) ausgerichtetes Linsensystem (8), wobei die Bodenplatte (1), der Abstandhalter (7) und das Linsensystem (8) aus Materialien mit zumindest ähnlichen thermischen Ausdehnungskoeffizienten bestehen,
**dadurch gekennzeichnet** , daß
der Abstandhalter (7) aus Glas besteht.

2. Wandler nach Anspruch 1,
**dadurch gekennzeichnet**, daß
die Bodenplatte (1) und das Linsensystem (8) aus Silizium bestehen.

3. Wandler nach einem der Ansprüche 1 oder 2,
**dadurch gekennzeichnet**, daß die Bodenplatte (1) mit einer Metallschicht (5) versehen ist, auf der das Halbleiterbauelement (6) befestigt ist.

4. Wandler nach einem der Ansprüche 1 bis 3,
**dadurch gekennzeichnet**, daß die aus Glas mit den aus Silizium bestehenden Teilen jeweils durch anodisches Bonden miteinander verbunden sind.

5. Wandler nach einem der Ansprüche 1 bis 4,
**dadurch gekennzeichnet**, daß jeweils aus Glas bzw. aus Silizium bestehende Teile miteinander verlötetet oder verklebt sind.

6. Wandler nach einem der Ansprüche 1 bis 5,
**dadurch gekennzeichnet**, daß das Halbleiterbauelement (6) in einer Vertiefung (2) der Bodenplatte (1) sitzt.

7. Wandler nach einem der Ansprüche 1 bis 6,
**dadurch gekennzeichnet**, daß die Bodenplatte (1) aus Silizium besteht und daß sie auf der vom Halbleiterbauelement (6) abgewandten Seite mit einer Glasplatte (10) verbunden ist.

8. Optoelektronisches Bauelement ,
**dadurch gekennzeichnet** , daß
ein optoelektronischer Wandler nach einem der Ansprüche 1 bis 8 relativ zum Fenster (16) justiert auf einem Sockel (14) befestigt ist, daß ein Gehäuse vorgesehen ist, das den Sockel (14) auf einen Deckel (15) mit einem Fenster (16) aufweist.

9. Verfahren zum Herstellen eines optoelektronischen Wandlers nach Anspruch 1,
**gekennzeichnet durch** die Merkmale:
a) In der Bodenplatte (1) werden Vertiefungen (2) zur Aufnahme der Halbleiterbauelemente (6) erzeugt derart, daß mindestens auf einer Seite jeder Vertiefung ein Steg (3) stehen bleibt,
b) auf die Stege wird eine Platte (17) von der Größe der Bodenplatte (1) aufgelegt und mit den Stegen (3) stoffschlüssig verbunden,
c) die Platte (17) wird zwischen den Stegen (3) entfernt, so daß mit der Bodenplatte (1) verbundene Abstandhalter (7) entstehen,
d) in die Vertiefungen (2) werden gemäß einem vorgegebenen Raster die Halbleiterbauelemente (6) eingesetzt und mit der Bodenplatte (1) verbunden,
e) auf die Träger wird eine weitere Platte (18) aufgelegt, die eine der Anzahl der Halbleiterbauelemente entsprechende Zahl von Linsensystemen (8) enthält, die gemäß dem gleichen Raster auf der weiteren Platte angeordnet sind,
f) die weitere Platte (18) wird bezüglich der Träger derart justiert, daß jedes der Linsensysteme auf eines der Halbleiterbauelemente ausgerichtet ist,
g) die weitere Platte (18) wird auf den Trägern befestigt,
h) der aus Bodenplatte, Halbleiterbauelementen, Abstandhaltern und weiterer Platte bestehende Verbund wird durch erste parallele Schnitte (13) und dazu rechtwinkelige zweite Schnitte zerteilt so daß Einheiten (11) entstehen, die jeweils eine Bodenplatte (1), ein Halbleiterbauelement (6), Abstandhalter (7) und ein Linsensystem (8) enthalten.

10. Verfahren nach Anspruch 9,
**dadurch gekennzeichnet**, daß jede der Einheiten (11) in ein gasdichtes Gehäuse (14, 15) eingesetzt wird.

## Claims

1. Optoelectronic transducer having a radiation-receiving or -emitting semiconductor component having a baseplate (1) on which the semiconductor component (6) is fixed and having a spacer (7) connected to the baseplate (1), for a lens system (8) which is oriented optically towards the semiconductor component (6), the baseplate (1), the spacer (7) and the lens system (8) being composed of materials having at least similar thermal expansion coefficients,
characterized in that the spacer (7) is composed of glass.

2. Transducer according to Claim 1,
characterized in that the baseplate (1) and the lens system (8) are composed of silicon.

3. Transducer according to either of Claims 1 and 2,
characterized in that the baseplate (1) is provided with a metal layer (5) on which the semiconductor component (6) is fixed.

4. Transducer according to one of Claims 1 to 3,
characterized in that the parts composed of glass together with those composed of silicon are in each case connected to one another by anodic bonding.

5. Transducer according to one of Claims 1 to 4,
characterized in that respective parts composed of glass and/or of silicon are soldered or adhesively bonded to one another.

6. Transducer according to one of Claims 1 to 5,
characterized in that the semiconductor component (6) is seated in a depression (2) in the baseplate (1).

7. Transducer according to one of Claims 1 to 6,
characterized in that the baseplate (1) is composed of silicon, and in that the said baseplate is connected to a glass plate (10) on that side which is remote from the semiconductor component (6).

8. Optoelectronic component,
characterized in that an optoelectronic transducer according to one of Claims 1 to 7 is fixed on a pedestal (14) in a manner aligned relative to the window (16), in that a housing is provided which has the pedestal (14) and a cover (15) with a window (16).

9. Method for producing an optoelectronic transducer according to Claim 1,
characterized by the following features:
a) depressions (2) for receiving the semiconductor components (6) are produced in the baseplate (1) in such a way that a web (3) remains at least on one side of each depression,
b) a plate (17) of the size of the baseplate (1) is placed onto the webs and connected to the webs (3) by a material joint,
c) the plate (17) is removed between the webs (3), thereby producing spacers (7) connected to the baseplate (1),
d) the semiconductor components (6) are inserted into the depressions (2) in accordance with a predetermined grid pattern and connected to the baseplate (1),
e) a further plate (18) is placed onto the carrier, which plate contains a number of lens systems (8) corresponding to the number of semiconductor components, which lens systems are arranged on the further plate in accordance with the same grid pattern,
f) the further plate (18) is aligned with regard to the carrier in such a way that each of the lens systems is oriented towards one of the semiconductor components,
g) the further plate (18) is fixed on the carriers,
h) the composite comprising baseplate, semiconductor components, spacers and further plate is divided by first parallel cuts (13) and second cuts at right angles thereto, thereby producing units (11) each containing a baseplate (1), a semiconductor component (6), spacers (7) and a lens system (8).

10. Method according to Claim 9,
characterized in that each of the units (11) is inserted into a gas-tight housing (14, 15).

## Revendications

1. Convertisseur optoélectronique comportant un composant à semiconducteur recevant ou émettant un faisceau, comportant une plaque (1) de fond, à laquelle est fixé le composant (6) à semiconducteur, et comportant une entretoise (7), reliée à la plaque (1) de fond, pour un système (8) de lentille orienté du point de vue optique vers le composant (6) à semiconducteur, la plaque (1) de fond, l'entretoise (7) et le système (8) de lentille étant en des matériaux ayant des coefficients de dilatation thermique au moins similaires, caractérisé en ce que l'entretoise (7) est en verre.

2. Convertisseur suivant la revendication 1, caractérisé en ce que la plaque (1) de fond et le système (8) de lentille sont en silicium.

3. Convertisseur suivant l'une des revendications 1 ou 2, caractérisé en ce que la plaque (1) de fond est munie d'une couche (5) métallique à laquelle le composant (6) à semiconducteur est fixé.

4. Convertisseur suivant l'une des revendications 1 à 3, caractérisé en ce que les pièces en verre sont reliées aux pièces en silicium par liaison anodique.

5. Convertisseur suivant l'une des revendications 1 à 4, caractérisé en ce que des pièces en verre ou en silicium sont brasées ou collées les unes aux autres.

6. Convertisseur suivant l'une des revendications 1 à 5, caractérisé en ce que le composant (6) à semiconducteur se tient dans un renfoncement (2) de la plaque (1) de fond.

7. Convertisseur suivant l'une des revendications 1 à 6, caractérisé en ce que la plaque (1) de fond est en silicium et en ce qu'elle est reliée à une plaque (10) de verre du côté éloigné du composant (6) à semiconducteur.

8. Composant optoélectronique, caractérisé en ce qu'un convertisseur optoélectronique suivant l'une des revendications 1 à 8, est fixé à un culot (14) en étant ajusté par rapport à la fenêtre (16), en ce qu'il est prévu un boîtier qui comporte le culot (14) sur un couvercle (15) comportant une fenêtre (16).

9. Procédé de fabrication d'un convertisseur optoélectronique suivant la revendication 1, caractérisé par les dispositions :
a) on produit dans la plaque (1) de fond des renfoncements (2) pour la réception des composants (6) à semiconducteur de telle manière qu'il reste au moins d'un côté de chaque renfoncement une barrette (3),
b) on dépose sur les barrettes une plaque (17) de la dimension de la plaque (1) de fond et on la relie par coopération de matière aux barrettes (3),
c) on enlève la plaque (17) entre les barrettes (3) si bien qu'il se forme des entretoises (7) reliées à la plaque (1) de fond,
d) on introduit dans les renfoncements (2) les éléments (6) à semiconducteur suivant une matrice prescrite et on les relie à la plaque (1) de fond,
e) on dépose sur le support une plaque (18) supplémentaire qui contient un nombre de systèmes (8) de lentilles correspondant au nombre des composants à semiconducteur, les systèmes de lentilles étant disposés suivant la même matrice sur la plaque supplémentaire,
f) on ajuste la plaque (18) supplémentaire par rapport aux supports de telle manière que chacun des systèmes de lentilles est orienté vers l'un des composants à semiconducteur,
g) on fixe la plaque (18) supplémentaire aux supports,
h) on décompose l'élément composite constitué de la plaque de fond, des composants à semiconducteur, des entretoises et de la plaque supplémentaire par une première découpe (13) parallèle et par une seconde découpe perpendi-culaire à la précédente, si bien que l'on obtient des unités (11) qui contiennent chacune une plaque (1) de fond, un composant (6) à semiconducteur, des entretoises (7) et un système (8) de lentille.

10. Procédé suivant la revendication 9, caractérisé en ce que l'on introduit chacune des unités (11) dans un boîtier (14, 15) étanche au gaz.
